Europäisches Patentamt

European Patent Office

Office européen des brevets

(11) Publication number: **0 213 819 B1**

# EUROPEAN PATENT SPECIFICATION

(45) Date of publication of patent specification: **24.07.91**　(51) Int. Cl.⁵: **H01R 23/72**, H01R 31/08, H01R 9/09

(21) Application number: **86306159.4**

(22) Date of filing: **08.08.86**

(54) Shunt connecting apparatus.

(30) Priority: **12.08.85 JP 122785/85 U**

(43) Date of publication of application:
**11.03.87 Bulletin 87/11**

(45) Publication of the grant of the patent:
**24.07.91 Bulletin 91/30**

(84) Designated Contracting States:
**AT BE CH DE FR GB IT LI LU NL SE**

(56) References cited:
**EP-A- 0 041 308**
**DE-B- 1 212 185**
**US-A- 3 349 361**

(73) Proprietor: **E.I. DU PONT DE NEMOURS AND COMPANY**
**1007 Market Street**
**Wilmington Delaware 19898(US)**

(72) Inventor: **Abe, Hiroshi**
**4-1-24-1104 Shirahata**
**Urawa-shi Saitama-ken(JP)**

(74) Representative: **Barnard, Eric Edward et al**
**BROOKES & MARTIN High Holborn House**
**52/54 High Holborn**
**London WC1V 6SE(GB)**

**Description**

FIELD OF THE INVENTION

The invention relates to connecting apparatus for electrically interconnecting a plurality of terminals mounted on a printed circuit board.

BACKGROUND OF THE INVENTION

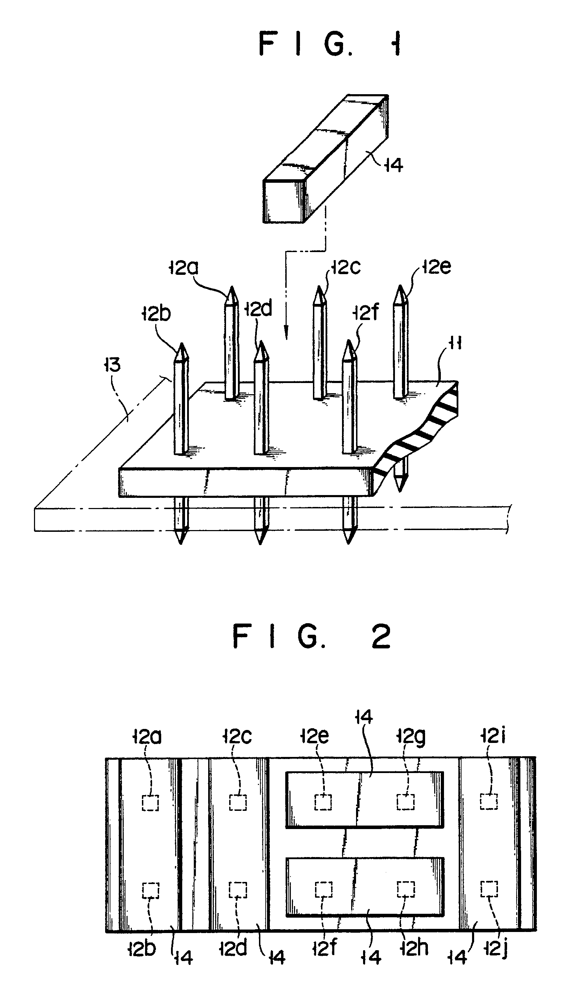

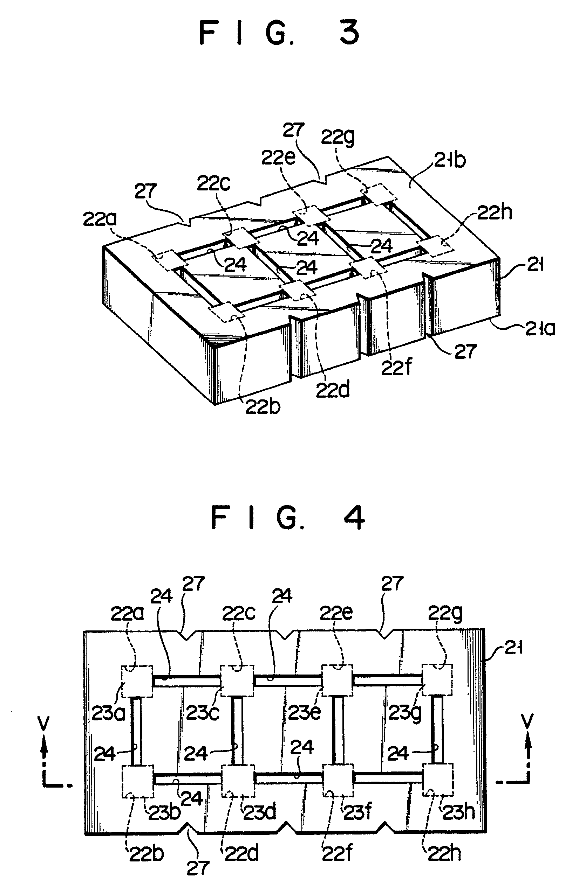

In one known form of connecting apparatus, illustrated in Figs. 1 and 2 of the accompanying drawings and described in more detail hereinafter, individual terminals mounted on a printed circuit board can be selectively interconnected, but only in adjacent pairs, by means of jumpers fitted onto the terminals. In another form of connecting apparatus a switchable device serves to interconnect selected terminals but such a device is complicated and expensive.

SUMMARY OF THE INVENTION

A general object of the invention is to provide a cheap simple connecting apparatus which has improved utility.

Connecting apparatus constructed in accordance with the invention comprises a generally rectangular housing having opposed faces and sides, at least three holes formed in one face of the housing, a plurality of terminals located in the holes to project outwardly from the one face of said housing for mouting to a printed circuit board; a plurality of grooves formed to interconnect respective pairs of the holes and expose the terminals therein and at least one conductive contact piece shaped for insertion into one of the grooves to contact the terminals in the associated holes and thereby to shunt these terminals.

Conveniently, the holes are blind to locate the terminals within the housing and the grooves are located in the opposite face of the housing from which the terminals project as an array. The holes and terminals may be disposed to form a matrix with rows and columns in plan view with the grooves extending between adjacent holes in both the rows and columns. By using a number of contact pieces selected groups of terminals can be interconnected and just two contact pieces will serve to contact any one terminal to two adjacent terminals. Terminals not at the boundaries of the rows and columns can be connected to more than two other adjacent terminals by using an appropriate number of contact pieces.

The contact pieces can take a variety of different forms but preference is given to a structure with a resilient base portion which fits into a groove and contacts a pair of terminals with its outer regions. The distance between these outer regions can be greater than the length of the grooves to permit the contact piece to be pushed in the groove to make reliable contact and retain the contact piece in the housing until it is to be foreceably removed. To enhance the resiliency of the base portion some relief as a cutout or recess is desirable.

BRIEF DESCRIPTION OF THE DRAWINGS

The invention may be understood more readily and various other features of the invention may become apparent from consideration of the following description.

In the accompanying drawings, Fig. 1 is a perspective view of a known form of connecting apparatus;

Fig. 2 is a plan view of the connecting apparatus of Fig. 1;

Fig. 3 is a perspective view of a housing part of the connecting apparatus constructed in accordance with the invention;

Fig. 4 is a plan view of the housing shown in Fig. 3;

Fig. 5 is a cross section of the housing taken on the line V-V of Fig. 4 and showing a contact piece inserted; and

Fig. 6 is a plan view of the connecting housing of another connecting apparatus constructed in accordance with the invention.

In the prior art shunt connecting apparatus shown in Fig. 1, two rows of terminals 12a to 12f are supported at specified intervals by a plate 11 and the terminals 12a to 12f are inserted through holes provided in printed circuit board 13 to connect electrically with the wiring pattern track formed on the rear side of board 13, by soldering. A plurality of separate jumpers 14 are provided. Each jumper has an insulative housing containing a metal terminal provided with two sockets, into which two adjacent terminals, for example 12c and 12d, may be inserted.

As is shown in Fig. 2, any two adjacent terminals can be shunted by inserting them to the sockets of a jumper 14. With this kind of arrangement, however, the combinations of shunted terminals are restricted, and it is impossible to make connection between one terminal and two other terminals.

DETAILED DESCRIPTION OF THE PREFERRED EMBODIMENTS

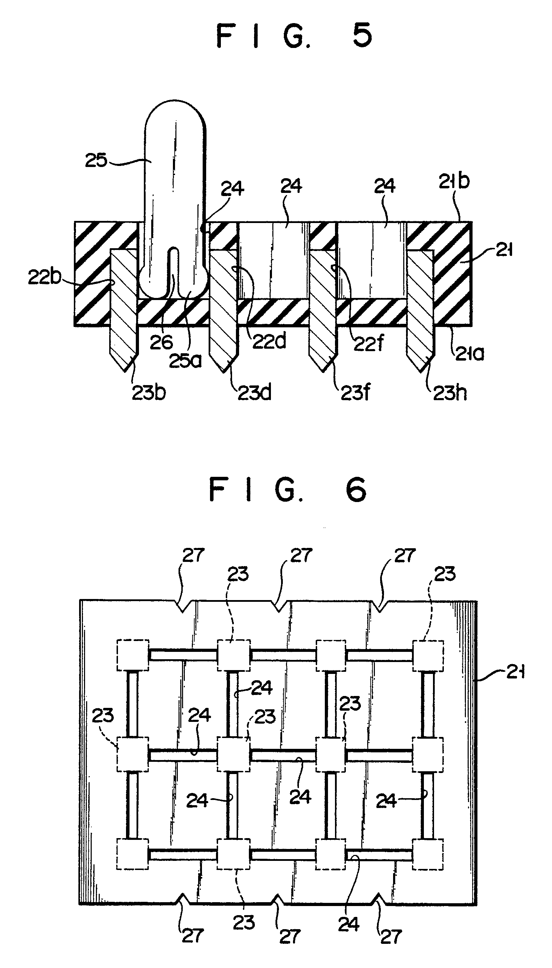

In Figs. 3 to 6, reference numeral 21 denotes an insulative rectangular housing conveniently formed of a synthetic resin. On the bottom face 21a of the housing 21 there are a number, typically eight (Figs. 3 and 4) or twelve (Fig. 6), blind holes 22a to 22h, of rectangular cross-section which do not extend to the other face 21b of the housing 21. The holes 22a to 22b are arranged as a matrix in plan view with two rows and four columns (Figs. 3 and 4) or three rows and four columns (Fig. 6) with equal spacing between respective holes.

Conductive terminals 23a to 23h made of metal have their bases inserted in the holes 22a to 22h and the tips of the terminals 23a to 23h protrude from the side 21a of the housing 21. At least the bases of the terminals 23a to 23h have a rectangular cross section that is substantially the same as that of the holes 22a to 22h. The bases of the terminals 23a to 23h are fixed to the housing 21 by inserting them forcibly into the holes 22a to 22h. Alternatively, terminals 23a to 23h may be fastened to the housing 21 by other means such as adhesives, etc. The projecting portions or tips of the terminals 23a to 23h penetrate the holes formed in the printed circuit board (not shown) and can be soldered to the wiring pattern track on the rear of a printed circuit board.

Grooves 24 are formed in the other face 21b, of the housing 21 to interconnect adjacent pairs of holes 22a to 22h. In this way, the interior portions or bases of the terminals 23a to 23h are exposed at both ends of each groove 24. The grooves 24 are narrower than the holes 22a to 22h.

As generally represented in Fig. 5, one or more resilient contact pieces 25 are inserted into selected grooves 24 in order to establish connection between respective terminals 23a to 23h (e.g. 23b and 23d in Fig. 5). The contact piece 25 is formed from one sheet of thin conductive metal with a base 25a which has a greater width than the rest of the component. The base 25a is also slightly wider than the length of the grooves 24, or, in other words, slightly wider than the gap between a pair of terminals 23a to 23g, and has a thickness thinner than the width of the guide groove 24. In approximately the centre of the base 25a of the contact piece 25 a recess or cutout 26 is formed longitudinally of the contact piece 25 to permit the base 25a of the contact piece 25 to be deformed resiliently.

When a contact piece 25 is inserted into one of the grooves 24, the base 25a exerts an outwardly directed expansive force in the direction of its width and its outer regions make resilient contact with the bases of the terminals 23a to 23h, exposed to the groove 24 and the terminals are thereby shunted. Although not strictly necessary, the overall length of the contact piece 25 is such that the tip protrudes from the housing 21 to facilitate its fitting and removal by hand or by using tools such as tweezers. Instead of producing the contact piece 25 from the one piece of material a composite structure can be adopted with say the top and base made from one material and the remainder from another material.

In Fig. 4, if, for example, contact pieces 25 are inserted into the grooves 24 between terminal 23d and terminals 23b, 23c, 23f, then the terminals 23b, 23c, 23d, 23f, are all shunted. Thus a branch connection from one terminal to three other terminals is possible and the maximum number of terminals which can be interconnected is four.

In the Fig. 6 version with three rows of terminals, if, for example, contact pieces 25 are inserted into the grooves 24 between one of the two central terminals and the surrounding terminals a branch connection from this terminal to four other terminals is established and the maximum number of terminals which can be interconnected is five. There is no limitation on the number of rows or columns of terminals which can be adopted.

As is shown in Figs. 3, 4 and 6, notches 27 are cut in the two opposite longitudinal sides of the housing 21 so that a notch on one side is aligned with a corresponding notch on the other side. The notches 27 permit the housing 21 to be sub-divided into a plurality of pieces along lines between a pair of the notches 27 if the application so requires.

With the connecting apparatus as described, it is possible to make a branch connection from one terminal to two or more other terminals and this greatly increases the utility of the apparatus. Since the terminals 23 do not protrude from the surface 21b of the housing 21, the structure and shape are uncomplicated and the apparatus is easy to handle. Furthermore, the contact pieces 25 do not need any holders so they occupy small space. The terminals can also be arranged close to each other, to reduce the overall size of the apparatus.

The shape of the contact piece 25 is also not restricted to that shown. Any shape which permits contact with the facing terminals, when the contact piece 25 is inserted into the appropriate groove 24 can be adopted. The cross sections of the terminals 23 and the holes 22 into which they are inserted need not be rectangular and other shapes can be adopted. Although the terminals 23 are depicted as arranged in a regular matrix this again is not essential and other irregular arrangements with the terminals staggered are possible.

**Claims**

1. A connecting apparatus comprising: a generally rectangular housing (21) having opposed faces and sides, at least three holes (22) formed in one face (21a) of the housing, a plurality of terminals (23) located in the holes (22) to project outwardly from the one face (21a) of said housing for mouting to a printed circuit board; a plurality of grooves (24) formed to interconnect respective pairs of the holes and expose the terminals therein and at least one conductive contact piece (25) shaped for insertion into one of the grooves (24) to contact the terminals in the associated holes and thereby to shunt these terminals.

2. A connecting apparatus according to claim 1, wherein the grooves (24) are formed in the opposite face (21b) of the housing (21).

3. A connecting apparatus according to claim 1 or 2, wherein said holes are blind holes, and each terminal (23) terminates at the end remote from its projecting portion within the housing.

4. A connecting appartus according to any one of claims 1 to 3, wherein at least a base portion (25a) of said contact piece (25) is resilient and the base portion has outer regions which expand to contact the terminals in the holes associated with the groove containing the contact piece and removably retain the contact piece in said housing.

5. A connecting apparatus according to claim 4, wherein the base portion of said contact piece is thinner than the width of each groove and the distance between the outer regions is greater than the length of each groove.

6. A connecting apparatus according to claim 4 or 5, wherein the base portion of said contact piece is relieved with at least one recess.

7. A connecting apparatus according to claim 4 or 5, wherein the base portion of said contact piece is bifurcated.

8. A connecting apparatus according to any one of claims 1 to 7, wherein each terminal has at least one side flat surface for contact by the contact piece.

9. A connecting apparatus according to any one of claims 1 to 8, wherein there are more than three holes and three terminals and a plurality of contact pieces, the holes and terminals being disposed to form a matrix with rows and columns in plan view with the grooves extending between adjacent holes in both the rows and columns whereby two contact pieces can be located in respective grooves to interconnect any one terminal to two adjacent terminals.

10. A connecting apparatus according to any one of claims 1 to 9, wherein the cross section of each hole and terminal is substantially square.

11. A connecting apparatus according to any one of claims 1 to 10, wherein opposed sides of the housing are provided with aligned notches (27) which permit the housing to be sub-divided along lines joining corresponding pairs of notches.

**Revendications**

1. Un dispositif de connexion, comprenant: un boîtier (21) généralement rectangulaire, présentant des faces et des côtés opposés, au moins trois trous (22) ménagés dans une face (21a) du boîtier, une pluralité de bornes (23) placées dans les trous (22) afin de faire saillie à l'extérieur d'une face (21a) dudit boîtier, pour le montage sur une plaquette de circuit imprimé; une pluralité de rainures (24) formées pour interconnecter des paires respectives de trous et y exposer les bornes et au moins une pièce de contact conductrice (25), conformée pour l'insertion dans l'une des rainures (24), pour entrer en contact avec les bornes situées dans les trous associés de manière à connecter en parallèle ces bornes.

2. Un dispositif de connexion selon la revendication 1, dans lequel les rainures (24) sont formées dans la face opposée (21b) du boîtier (21).

3. Un dispositif de connexion selon la revendication 1 ou 2, dans lequel lesdits trous sont des trous borgnes, et chaque borne (23) se termine à l'extrémité éloignée de sa partie en saillie à l'intérieur du boîtier.

4. Un dispositif de connexion selon l'une quelconque des revendications 1 à 3, dans lequel au moins une partie de base (25a) de ladite pièce de contact (25) est élastique et la partie de base présente des zones extérieures qui se déploient pour entrer en contact avec les bornes dans les trous associés à la rainure qui contient la pièce de contact et pour maintenir la pièce de contact de façon amovible dans ledit boîtier.

5. Un dispositif de connexion selon la revendication 4, dans lequel la largeur de la partie de base de ladite pièce de contact est inférieure à la largeur de chaque rainure et la distance entre les zones extérieures est supérieure à la longueur de chaque rainure.

6. Un dispositif de connexion selon la revendication 4 ou 5, dans lequel la partie de base de ladite pièce de contact est dégagée par au moins une cavité.

7. Un dispositif de connexion selon la revendication 4 ou 5, dans lequel la partie de base de ladite pièce de contact est en forme de fourche.

8. Un dispositif de connexion selon l'une quelconque des revendications 1 à 7, dans lequel chaque borne présente au moins une surface latérale plane pour venir en contact avec la pièce de contact.

9. Un dispositif de connexion selon l'une quelconque des revendications 1 à 8, dans lequel sont prévus plus de trois trous et de trois bornes et une pluralité de pièces de contact, les trous et les bornes étant disposés pour former une matrice avec des lignes et des colonnes en vue en plan, les rainures s'étendant entre des trous adjacents, à la fois dans les lignes et les colonnes, de manière à ce que deux pièces de contact puissent être placées dans des rainures respectives pour interconnecter l'une quelconque des bornes à deux bornes adjacentes.

10. Un dispositif de connexion selon l'une quelconque des revendications 1 à 9, dans lequel la section transversale de chaque trou et chaque borne est sensiblement carrée.

11. Un dispositif de connexion selon l'une quelconque des revendications 1 à 10, dans lequel des côtés opposés du boîtier sont pourvus d'encoches alignées (27) qui permettent au boîtier d'être subdivisé suivant les lignes qui relient des paires correspondantes d'encoches.

**Patentansprüche**

1. Verbindungsvorrichtung, welche aufweist: ein im allgemeinen rechteckiges Gehäuse (21) das gegenüberliegende Flächen und Seiten hat, wenigstens drei Öffnungen (22), die in einer Fläche (21a) des Gehäuses ausgebildet sind, eine Mehrzahl von Anschlüssen (23), die in den Öffnungen (22) liegen, um von einer Fläche (21a) des Gehäuses nach außen zur Anbringung einer gedruckten Schaltungsplatte vorzustehen, eine Mehrzahl von Ausnehmungen (24), die ausgebildet sind, um eine Zwischenverbindung zwischen zugeordneten Paaren von Öffnungen zu bilden und die Anschlüsse darin freizulegen, und wenigstens ein leitendes Kontaktstück (25), welches derart ausgebildet ist, daß es in eine der Ausnehmungen (24) einführbar ist, um die Anschlüsse in den zugeordneten Öffnungen zu kontaktieren und hierdurch diese Anschlüsse parallel zu schalten.

2. Verbindungsvorrichtung nach Anspruch 1, bei der die Ausnehmungen (24) in der gegenüberliegenden Fläche (21b) des Gehäuses (21) ausgebildet sind.

3. Verbindungsvorrichtung nach Anspruch 1 oder 2, bei der die Öffnungen Blindbohrungen sind und jeder Anschluß (23) an einem von dem vorspringenden Abschnitt in dem Gehäuse entfernt liegenden Ende endet.

4. Verbindungsvorrichtung nach einem der Ansprüche 1-3, bei der wenigstens ein Basisabschnitt (25a) des Kontaktstücks (25) federnd nachgiebig ist, und der Basisabschnitt äußere Bereiche hat, die sich erweitern, um die Anschlüsse in den Öffnungen zu kontaktieren, die der Ausnehmung zugeordnet sind, die das Kontaktstück enthält und bei der das Kontaktstück in dem Gehäuse lösbar festgehalten ist.

5. Verbindungsvorrichtung nach Anspruch 4, bei der der Basisabschnitt des Kontaktstücks dünner als die Breite der jeweiligen Nut ist, und der Abstand zwischen den äußeren Bereichen größer als die Länge der jeweiligen Nut ist.

6. Verbindungsvorrichtung nach Anspruch 4 oder 5, bei der der Basisabschnitt des Kontaktstücks mit wenigstens einer Ausnehmung ausgespart ist.

7. Verbindungsvorrichtung nach Anspruch 4 oder 5, bei der der Basisabschnitt des Kontaktstücks gabelförmig ausgebildet ist.

8. Verbindungsvorrichtung nach einem der Ansprüche 1-7, bei der der Anschluß wenigstens eine ebene Seitenfläche zum Kontakt durch das Kontaktstück hat.

9. Verbindungsvorrichtung nach einem der Ansprüche 1-8, bei der mehr als drei Öffnungen und mehr als drei Anschlüsse und eine Mehrzahl von Kontaktstücken vorgesehen sind, die Öffnungen und Anschlüsse derart angeordnet sind, daß eine Matrix mit Reihen und Spalten in einer Draufsicht gebildet wird, wobei die Ausnehmungen zwischen benachbarten Öffnungen in den Reihen und Spalten verlaufen, und wobei zwei Kontaktstücke in zugeordnete Ausnehmungen derart anordenbar sind, daß eine Zwischenverbindung zwischen jeweils einem Anschluß und zwei benachbarten Anschlüssen hergestellt wird.

10. Verbindungsvorrichtung nach einem der Ansprüche 1-9, bei der der Querschnitt jeder Öffnung und jedes Anschlußes im wesentlichen quadratisch ist.

11. Verbindungsvorrichtung nach einem der Ansprüche 1-10, bei der die gegenüberliegenden Seiten des Gehäuses mit fluchtenden Ausnehmungen (27) versehen sind, welche gestatten, daß das Gehäuse längs Verbindungslinien entsprechend den Paaren von Ausnehmungen unterteilbar ist.

# F I G. 1

# F I G. 2

# F I G. 3

## F I G. 4

# F I G. 5

25

24 24 24 21b

22b

22d 22f 21

26 25a

23b 23d 23f 23h

21a

# F I G. 6

27 27 27 23

23

21

24

23

23 23

24 24

24 24

27 23 27 24 27